# EUROPEAN PATENT APPLICATION

(11) **EP 3 148 294 A1**
(43) Date of publication of application: **29.03.2017**
(21) Application number: 15822103.6
(22) Date of filing: 13.07.2015
(51) Int. Cl.: H05B 33/12, H01L 51/50

(54) **ORGANIC ELECTROLUMINESCENT ELEMENT AND LIGHTING DEVICE**

(30) Priority: 18.07.2014 JP 2014148305
(71) Applicant: Lumiotec Inc., Yamagata 992-1128 (JP)
(72) Inventor: MORIMOTO, Mitsuru, Yonezawa-shi Yamagata 992-1128 (JP); TANAKA, Junichi, Yonezawa-shi Yamagata 992-1128 (JP)
(74) Representative: Henkel, Breuer & Partner
(86) International application number: PCT/JP2015/070036
(87) International publication number: WO 2016/009991

(57) **Abstract**

This organic electroluminescent element comprises, between a negative electrode and a positive electrode, a plurality of light emitting units, each of which comprises at least a light emitting layer that is formed of an organic compound. With respect to this organic electroluminescent element, white light obtained by light emission of the plurality of light emitting units has an emission spectrum (S) that is continuous at least over a wavelength range of 380-780 nm. The emission spectrum (S) has one peak wavelength (p₁) in a red wavelength range (R) of 600-780 nm, one or two peak wavelengths (pₓ, p_{y}) in a green wavelength range (G) of 490-600 nm, and two peak wavelengths (p₂, p₃) in a blue wavelength range (B) of 380-490 nm.

## Description

### [Technical Field]

The present invention relates to an organic electroluminescent (EL) element and a lighting device.

Priority is claimed on Japanese Patent Application No. 2014-148305, filed July 18, 2014, the content of which is incorporated herein by reference.

### [Background Art]

An organic EL element is a self-luminous element that includes a light-emitting layer that is provided between a cathode and an anode that face each other and is made of an organic compound. When a voltage is applied between the cathode and the anode, the organic EL element emits light by excitons that are generated when electrons injected into the light-emitting layer from the cathode side and holes injected into the light-emitting layer from the anode side are recombined within the light-emitting layer.

Tang et al. of the Eastman Kodak Company proposed a structure in which, in order to obtain high efficiency of an organic EL element, organic compounds having different carrier transporting properties are laminated, and electrons and holes are injected into a cathode and an anode, respectively, with favorable balance. According to this structure, when a layer thickness of an organic layer interposed between the cathode and the anode is set to 2000 Å or less, a luminance of 1000 cd/m² is obtained at an applied voltage of 10 V or less. Accordingly, high luminance and high efficiency sufficient for practical applications having an external quantum efficiency of 1% are obtained (refer to Non-Patent Literature 1).

The patents of Tang et al. describe that it is possible to provide a device that can emit light at a lower applied voltage when a layer thickness of the entire organic layer interposed between the cathode and the anode is set to 1 µm or less. Preferably, when a layer thickness of the organic layer is set to a range of 1000 Å to 5000 Å, an electric field (V/cm) useful for obtaining light emitting at an applied voltage of 25 V or less is obtained (refer to Patent Literatures 1 to 6).

Organic EL elements have been developed based on the element structure proposed by Tang et al.

As an element structure of an organic EL element, an organic EL element having a tandem structure in which a light-emitting unit including at least one or more light-emitting layers is used as one unit, and a plurality of light-emitting units are laminated to be connected in series between a cathode and an anode has been developed (refer to Patent Literatures 7 and 8).

In the above-described structure of the organic EL element proposed by Tang et al., a high current is necessary despite the low voltage. On the other hand, the organic EL element of the tandem structure is being focused on as a technology for implementing a long lifespan, high luminance and uniform light emission in a large area.

An organic EL element having a multi-photon emission (MPE) structure in which an electrically-insulating charge-generating layer (CGL) is disposed between a plurality of light-emitting units has been developed (refer to Patent Literatures 9 and 10). In the organic EL element having the MPE structure, when a voltage is applied between a cathode and an anode, charges in a charge-transfer complex move toward a cathode side and an anode side. Accordingly, holes are injected into one light-emitting unit that is positioned on the cathode side with the charge-generating layer interposed therebetween, and electrons are injected into the other light-emitting unit that is positioned on the anode side with the charge-generating layer interposed therebetween. Therefore, the plurality of light-emitting units may emit light simultaneously at the same amount of current without change. Accordingly, it is possible to obtain current efficiency and external quantum efficiency corresponding to the number of light-emitting units.

Characteristics of the above-described organic EL element include that it can switch light emission at a high rate and that it has a simple and thin element structure. The organic EL element takes advantage of such excellent characteristics and is applied to display devices of, for example, mobile phones and automotive devices. In recent years, by taking advantage of characteristics such as flat surface light emission, for example, a backlight of a liquid crystal display and a light source of a lighting device such as general lighting have been focused on.

In this case, when the organic EL element is applied to a lighting device, it is necessary to obtain white light that has a color temperature and a high color-rendering property over a wide range. Exemplary methods of obtaining white light in the organic EL element include a method in which light beams emitted from light-emitting materials of two colors having a relation of complementary colors, for example, a blue light-emitting layer and a yellow light-emitting layer, are mixed to obtain white and a method in which light beams emitted from three light-emitting layers of red, blue, and green are mixed to obtain white. Among the methods, the method in which light beams emitted from three light-emitting layers of red, blue, and green are color-mixed is appropriate for obtaining white light having a high color-rendering property (refer to Patent Literatures 11 and 12).

However, it is hard to say that, in organic EL elements of the related art, a light emission spectrum of white light obtained by light emission of three light-emitting layers of red, blue, and green is necessarily sufficiently controlled in consideration of obtaining a color temperature and a high color-rendering property over a wide range. That is, the organic EL elements of the related art did not have necessarily sufficient performance as a light source of a lighting device.

### [Citation List]

### [Patent Literature]

[Patent Literature 1]
   Japanese Unexamined Patent Application, First Publication No. S59-194393
[Patent Literature 2]
   Japanese Unexamined Patent Application, First Publication No. S63-264692
[Patent Literature 3]
   Japanese Unexamined Patent Application, First Publication No. H2-15595
[Patent Literature 4]
   United States Patent No. 4,539,507 specification
[Patent Literature 5]
   United States Patent No. 4,769,292 specification
[Patent Literature 6]
   United States Patent No. 4,885,211 specification
[Patent Literature 7]
   Japanese Unexamined Patent Application, First Publication No. H11-329748
[Patent Literature 8]
   Japanese Unexamined Patent Application, First Publication No. 2003-45676
[Patent Literature 9]
   Japanese Unexamined Patent Application, First Publication No. 2003-272860
[Patent Literature 10]
   Japanese Unexamined Patent Application, First Publication No. 2006-24791
[Patent Literature 11]
   Japanese Unexamined Patent Application, First Publication No. 2006-287154
[Patent Literature 12]
   Japanese Unexamined Patent Application, First Publication No. 2009-224274

### [Non-Patent Literature]

[Non-Patent Literature 1]
Appl. Phys. Lett., 51,913 (1987).

### [Summary of Invention]

### [Technical Problem]

The present invention has been proposed in view of the above-described circumstance of the related art, and provides an organic electroluminescent element that obtains white light having a color temperature and a high color-rendering property over a wide range, and thus is particularly suitable for a light source of a lighting device and a lighting device including such an organic electroluminescent element.

### [Solution to Problem]

In order to achieve the above object, the present invention provides the following aspects. An organic electroluminescent element according to a first aspect of the present invention includes a plurality of light-emitting units that are provided between a cathode and an anode and include a light-emitting layer made of at least an organic compound, and in the organic electroluminescent element, white light obtained by light emission of the plurality of light-emitting units has a light emission spectrum that is continuous over a wavelength range of at least 380 to 780 nm, and the light emission spectrum includes one peak wavelength in a red wavelength range of 600 to 780 nm, at least one or two peak wavelengths in a green wavelength range of 490 to 600 nm, and two peak wavelengths in a blue wavelength range of 380 to 490 nm.

In an organic electroluminescent element according to a second aspect of the present invention, in the first aspect, a first light-emitting unit including a red phosphorescent light-emitting layer that emits red light having one peak wavelength in the red wavelength range and a green phosphorescent light-emitting layer that emits green light having one peak wavelength in the green wavelength range, and a second light-emitting unit including a blue fluorescent light-emitting layer that emits blue light having two peak wavelengths in the blue wavelength range and a green fluorescent light-emitting layer that emits green light having one peak wavelength in the green wavelength range may be provided.

In an organic electroluminescent element according to a third aspect of the present invention, in the second aspect, in the second light-emitting unit, the blue fluorescent light-emitting layer may be disposed on the anode side and the green fluorescent light-emitting layer may be disposed on the cathode side.

In an organic electroluminescent element according to a fourth aspect of the present invention, in the second or third aspect, red light emitted from the red phosphorescent light-emitting layer and green light emitted from the green phosphorescent light-emitting layer may be obtained by triplet excitons, and blue light emitted from the blue fluorescent light-emitting layer may be obtained by singlet excitons generated by collision and fusion of triplet excitons.

In an organic electroluminescent element according to a fifth aspect of the present invention, in any one of the first to fourth aspects, the white light may have a light emission color that is any of white (W), warm white (WW), and incandescent (L) among chromaticity ranges defined in JIS Z 9112.

In an organic electroluminescent element according to a sixth aspect of the present invention, in any one of the first to fifth aspects, when the white light has a light emission color that is any of warm white (WW) and incandescent (L) among chromaticity ranges defined in JIS Z 9112, and a maximum light emission intensity of a peak wavelength of red light is set as PR, a maximum light emission intensity of a peak wavelength of green light is set as PG, and a maximum light emission intensity of a peak wavelength of blue light is set as PB, relationships of PG/PR≤0.85 and PB/PR≥0.15 may be satisfied.

In an organic electroluminescent element according to a seventh aspect of the present invention, in any one of the first to sixth aspects, the white light may have an average color-rendering index (Ra) of 70 or more, and among special color-rendering indexes, R9 may be 30 or more, R12 may be 60 or more, and R13 and R15 may be 70 or more.

In an organic electroluminescent element according to an eighth aspect of the present invention, in any one of the first to seventh aspects, the organic electroluminescent element may have a structure in which the plurality of light-emitting units are laminated with a charge-generating layer interposed therebetween.

In an organic electroluminescent element according to a ninth aspect of the present invention, in the eighth aspect, the charge-generating layer may be an electrically-insulating layer made of an electron-accepting material and an electron-donating material, and the electrically-insulating layer may have a specific resistance of 1.0×102 Ω•cm or more.

In an organic electroluminescent element according to a tenth aspect of the present invention, in the ninth aspect, the electrically-insulating layer may have a specific resistance of 1.0×105 Ω•cm or more.

In an organic electroluminescent element according to an eleventh aspect of the present invention, in the eighth aspect, the charge-generating layer may be a mixed layer including different materials, one component thereof may be a metal oxide, and the metal oxide may form a charge-transfer complex according to an oxidation-reduction reaction, and when a voltage is applied between the cathode and the anode, charges in the charge-transfer complex may move toward the cathode side and the anode side, and thus holes may be injected into one light-emitting unit that is positioned on the cathode side with the charge-generating layer interposed therebetween, and electrons may be injected into the other light-emitting unit that is positioned on the anode side with the charge-generating layer interposed therebetween.

In an organic electroluminescent element according to a twelfth aspect of the present invention, in the eighth aspect, the charge-generating layer may have a laminated body including an electron-accepting material and an electron-donating material, and when a voltage is applied between the cathode and the anode, at an interface between the electron-accepting material and the electron-donating material, charges generated by a reaction according to electron movement between the electron-accepting material and the electron-donating material may move toward the cathode side and the anode side, and holes may be injected into one light-emitting unit that is positioned on the cathode side with the charge-generating layer interposed therebetween and electrons may be injected into the other light-emitting unit that is positioned on the anode side with the charge-generating layer interposed therebetween.

A lighting device according to a thirteenth aspect of the present invention includes the organic electroluminescent element according to any one of the first to twelfth aspects.

In a lighting device according to a fourteenth aspect of the present invention, in the thirteenth aspect, an optical film may be provided on a light extraction surface side of the organic electroluminescent element.

In a lighting device according to a fifteenth aspect of the present invention, in the fourteenth aspect, white light extracted from the optical film side may have a light emission spectrum that is continuous over a wavelength range of at least 380 to 780 nm, and the light emission spectrum may include one peak wavelength in the red wavelength range of 600 to 780 nm, at least one peak wavelength in the green wavelength range of 490 to 600 nm, and two peak wavelengths in the blue wavelength range of 380 to 490 nm.

In a lighting device according to a sixteenth aspect of the present invention, in the fourteenth or fifteenth aspect, white light extracted from the optical film side may have Ra of 70 or more, and among color-rendering indexes, R9 may be 30 or more, R12 may be 60 or more, and R13 and R15 may be 70 or more.

### [Advantageous Effects of Invention]

According to the present invention, it is possible to provide an organic electroluminescent element that obtains white light having a color temperature and a high color-rendering property over a wide range and a lighting device including such an organic electroluminescent element.

### [Brief Description of Drawings]

Fig. 1 is a graph showing an example of a light emission spectrum of white light obtained by an organic EL element to which the present invention is applied.
Fig. 2 is a cross-sectional view showing an example of an element structure of an organic EL element to which the present invention is applied.
Fig. 3 is a graph showing an example of a light emission spectrum of white light obtained when an optical film of a lighting device to which the present invention is applied is used.
Fig. 4 is a cross-sectional view showing an element structure of an organic EL element of Example 1.
Fig. 5 is a diagram showing an evaluation result obtained when an organic EL element of Example 1 has no optical film.
Fig. 6 is a diagram showing an evaluation result obtained when an organic EL element of Example I has an optical film.
Fig. 7 is a cross-sectional view showing an element structure of an organic EL element of Example 2.
Fig. 8 is a diagram showing an evaluation result obtained when the organic EL element of Example 2 has no optical film.
Fig. 9 is a diagram showing an evaluation result obtained when the organic EL element of Example 2 has an optical film.
Fig. 10 is a cross-sectional view showing an element structure of an organic EL element of Example 3.
Fig. 11 is a diagram showing an evaluation result obtained when the organic EL element of Example 3 has no optical film.
Fig. 12 is a diagram showing an evaluation result obtained when the organic EL element of Example 3 has an optical film.
Fig. 13 is a cross-sectional view showing an element structure of an organic EL element of Example 4.
Fig. 14 is a diagram showing an evaluation result obtained when the organic EL element of Example 4 has no optical film.
Fig. 15 is a diagram showing an evaluation result obtained when the organic EL element of Example 4 has an optical film.
Fig. 16 is a cross-sectional view showing an element structure of an organic EL element of Example 5.
Fig. 17 is a diagram showing an evaluation result obtained when the organic EL element of Example 5 has no optical film.
Fig. 18 is a diagram showing an evaluation result obtained when the organic EL element of Example 5 has an optical film.

### [Description of Embodiments]

Hereinafter, an organic electroluminescent (EL) element and a lighting device to which the present invention is applied will be described in detail with reference to the drawings.

In the drawings used in the following description, in order to facilitate understanding of features, feature parts are enlarged for convenience of illustration in some cases, and dimensional ratios of components are not actually necessarily the same. Materials, dimensions, and the like exemplified in the following description are only examples, and the present invention is not necessarily limited thereto but can be appropriately changed and implemented within ranges in which the scope and spirit of the invention are not changed.

An organic EL element of an embodiment to which the present invention is applied includes a plurality of light-emitting units that are provided between a cathode and an anode and include a light-emitting layer made of at least an organic compound. White light obtained by light emission of the plurality of light-emitting units has a light emission spectrum that is continuous over a wavelength range of at least 380 to 780 nm. The light emission spectrum includes one peak wavelength in a red wavelength range of 600 to 780 nm, at least one or two peak wavelengths in a green wavelength range of 490 to 600 nm, and two peak wavelengths in a blue wavelength range of 380 to 490 nm.

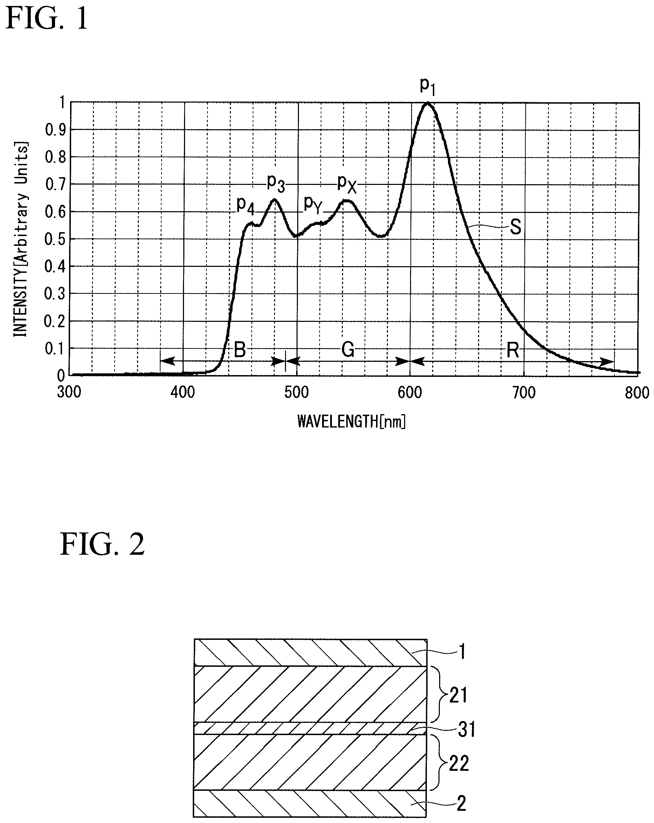

Fig. 1 is a graph showing an example of a light emission spectrum S of white light obtained by an organic EL element of an embodiment to which the present invention is applied. Specifically, white light obtained by the organic EL element has a light emission spectrum S that is continuous over a wavelength range of at least 380 to 780 nm of so-called visible light as shown in Fig. 1.

The light emission spectrum S includes one peak wavelength p₁ in the red wavelength range R of 600 to 780 nm, two peak wavelengths p_{X} and p_{Y} in the green wavelength range G of 490 to 600 nm, and two peak wavelengths p₃ and p₄ in the blue wavelength range B of 380 to 490 nm.

Accordingly, the organic EL element of the embodiment to which the present invention is applied can obtain white light having a color temperature and a high color-rendering property over a wide range. Specifically, in the organic EL element, among chromaticity ranges defined in JIS Z 9112, it is possible to obtain white light corresponding to any light color of white (W), warm white (WW), and incandescent (L). The organic EL element can obtain white light in which an average color-rendering index (Ra) is 70 or more (more preferably 80 or more) and among special color-rendering indexes, R9 is 30 or more, R12 is 60 or more, and R13 and R15 are 70 or more.

If a light emission color of white light is any of warm white (WW) and incandescent (L), when a maximum light emission intensity of a peak wavelength of red light is set as PR, a maximum light emission intensity of a peak wavelength of green light is set as PG, and a maximum light emission intensity of a peak wavelength of blue light is set as PB, the following relationships are preferably satisfied. PG/PR≤0.85,

### PB/PR≥0.15

When these two relational expressions are satisfied, it is possible to obtain any white light included in all areas among chromaticity ranges of any light color of warm white (WW) and incandescent (L), and it is possible to obtain a high color-rendering property.

In an embodiment of the present invention, the organic EL element in which such white light having a color temperature and a high color-rendering property over a wide range is obtained can be suitably used as, for example, a backlight of a liquid crystal display and a light source of a lighting device such as a general lighting. That is, the lighting device including the organic EL element of the embodiment to which the present invention is applied can emit white light having a color temperature and a high color-rendering property over a wide range. In the embodiment of the present invention, the organic EL element is not limited to a light source of a lighting device, but can be used for various applications.

The organic EL element of the embodiment to which the present invention is applied preferably has, for example, a structure in which a first light-emitting unit 21 and a second light-emitting unit 22 are laminated between a cathode 1 and an anode 2 (a tandem structure) as shown in Fig. 2, as an element structure for obtaining the above-described white light having a color temperature and a high color-rendering property over a wide range (a light emission spectrum S).

The first light-emitting unit 21 includes a red phosphorescent light-emitting layer that emits red light having one peak wavelength p₁ in the red wavelength range R and a green phosphorescent light-emitting layer that emits green light having one peak wavelength p_{X} on a long wavelength side of the green wavelength range G.

The second light-emitting unit 22 includes a blue fluorescent light-emitting layer that emits blue light having two peak wavelengths p₃ and p₄ in the blue wavelength range B and a green fluorescent light-emitting layer that emits green light having one peak wavelength p_{Y} on a short wavelength side of the green wavelength range G.

In the second light-emitting unit 22, the green fluorescent light-emitting layer is preferably disposed on the cathode 1 side. In the second light-emitting unit 22, the blue fluorescent light-emitting layer is preferably disposed on the anode 2 side.

When light-emitting layers that emit different colors are laminated, a light-emitting layer (corresponding to the blue fluorescent light-emitting layer here) that emits a light emission color having higher energy is disposed on the anode side, that is, a light extraction side. Accordingly, it is possible to extract light emitted from both of the light-emitting layers to the outside with high efficiency. On the other hand, when the green fluorescent light-emitting layer is disposed on the anode side, some of the blue light that is emitted from the blue fluorescent light-emitting layer is absorbed into the green fluorescent light-emitting layer. Therefore, an amount of blue light that is extracted to the outside is reduced and efficiency decreases as a result.

In the organic EL element of the embodiment to which the present invention is applied, red light emitted from the red phosphorescent light-emitting layer and green light emitted from the green phosphorescent light-emitting layer are preferably obtained by triplet excitons. In the organic EL element of the embodiment to which the present invention is applied, blue light emitted from the blue fluorescent light-emitting layer is preferably obtained by singlet excitons that are generated by collision and fusion of triplet excitons.

Red light and green light can be obtained from triplet excitons with high efficiency. On the other hand, although it is also desirable to obtain blue light from triplet excitons, it is disadvantageous in consideration of efficiency because there is no practical material. For this reason, light emission from practical singlet excitons is used for blue light. Blue light is obtained by singlet excitons that are generated by collision and fusion of triplet excitons that usually do not contribute to light emission among them, and thus blue light can also be obtained with high efficiency.

The organic EL element of the embodiment to which the present invention is applied preferably has a structure (MPE structure) in which the first light-emitting unit 21 and the second light-emitting unit 22 are laminated with a charge-generating layer (CGL) 31 interposed therebetween.

In the cathode 1, a metal having a small work function in general or an alloy thereof, an oxide thereof, or the like is preferably used. Specifically, in the cathode 1, a single metal, for example, an alkali metal such as Li, an alkaline earth metal such as Mg and Ca, a rare earth metal such as Eu, or an alloy including such a metal and Al, Ag, In, and the like can be used.

For example, as disclosed in "Japanese Unexamined Patent Application, First Publication No. H10-270171" and "Japanese Unexamined Patent Application, First Publication No. 2001-102175," the organic EL element of this embodiment may have a configuration using an organic layer doped with a metal at an interface between the cathode 1 and an organic layer. In this case, an electrically conductive material may be used for the cathode 1, and properties of the work function are not particularly limited.

For example, as disclosed in "Japanese Unexamined Patent Application, First Publication No. H11-233262" and "Japanese Unexamined Patent Application, First Publication No. 2000-182774," the organic EL element of this embodiment has an organic layer in contact with the cathode 1 and may be made of an organic metal complex compound that includes at least one of alkali metal ions, alkaline earth metal ions, and rare earth metal ions. In this case, a metal that can reduce metal ions included in the organic metal complex compound to a metal in a vacuum state, for example, a (thermally reducible) metal such as Al, Zr, Ti, and Si or an alloy including such a metal can be used for the cathode 1. Among them, particularly, Al that is generally widely used as a wiring electrode is preferably used in consideration of ease of deposition, a high optical reflectance, chemical stability, and the like.

A material for the anode 2 is not particularly limited, and when light is extracted from the anode 2 side, it is possible to use a transparent conductive material, for example, indium tin oxide (ITO) and indium zinc oxide (IZO).

For example, when the method disclosed in "Japanese Unexamined Patent Application, First Publication No. 2002-332567" is used and ITO is formed into a film by a sputtering method that does not damage an organic film, an organic layer doped with a metal disclosed in "Japanese Unexamined Patent Application, First Publication No. H10-270171" may be used as an electron injection layer. Accordingly, the above-described transparent conductive material such as ITO and IZO can be used for the cathode 1.

Therefore, it is possible to prepare a transparent organic EL element in which both the cathode 1 and the anode 2 are transparent (because the first light-emitting unit (organic films) 21, the second light-emitting unit (organic films) 22, and the charge-generating layer 31 are similarly transparent). Reversely to the case of a general organic EL element, when a metal material is used for the anode 2 and a transparent conductive material is used for the cathode 1, it is also possible to extract light from the cathode 1 side. The film formation order does not necessarily start from the anode 2 side, but film formation may start from the cathode 1 side.

Various structures similar to those of known organic EL elements of the related art can be employed for the first light-emitting unit 21 and the second light-emitting unit 22, and any laminate structure may be used as long as a light-emitting layer made of at least an organic compound is included. For example, an electron transport layer, an electron injection layer, and the like are disposed on the cathode 1 side of the light-emitting layer. On the other hand, a hole transport layer, a hole injection layer, and the like can be disposed on the anode 2 side of the light-emitting layer.

The electron transport layer may be formed using a known electron transporting material of the related art. Among electron transporting materials that are generally used for an organic EL element, in order to provide a favorable electron transporting property and ensure consistency of carrier balance, it is desirable to have a function of hole blocking. Specifically, an electron transporting material whose value of a highest occupied molecular orbital (HOMO) is a level of 6.0 eV or higher is preferably used. The electron injection layer is inserted between the cathode 1 and the electron transport layer, or the charge-generating layer 31 and the electron transport layer positioned on the anode 2 side in order to improve injection efficiency of electrons from the cathode 1 or the charge-generating layer 31. Therefore, an electron transporting material having a property similar to that of the electron transport layer is generally used for the electron injection layer. The electron transport layer and the electron injection layer may be referred to collectively as the electron transport layer.

The hole transport layer may be formed using a known hole transporting material of the related art, and is not particularly limited, but, for example, an organic compound (an electron-donating material) whose HOMO is less than 5.7 eV, and having a hole transporting property, that is, an electron-donating property, is preferably used. The hole injection layer is inserted between the anode 2 and the hole transport layer or between the charge-generating layer 31 and the hole transport layer that is positioned on the cathode 1 side in order to improve injection efficiency of holes from the anode 2 or the charge-generating layer 31. Therefore, in the hole injection layer, an electron-donating material having a property similar to that of the hole transport layer is generally used. The hole transport layer and the hole injection layer may be referred to collectively as the hole transport layer.

As a film formation method of layers of the first light-emitting unit 21 and the second light-emitting unit 22, for example, a vacuum deposition method or a spin coating method can be used. As materials used in the electron transport layer, the electron injection layer, the hole transport layer, and the hole injection layer described above, known materials of the related art can be used.

Red, green, and blue light-emitting layers of the first light-emitting unit 21 and the second light-emitting unit 22 usually include a host material that is a main component and a guest material that is a minor component as organic compounds. That is, red, green, and blue light emissions depend on specific properties of the guest material.

The guest material is also referred to as a dopant material. A guest material using fluorescent light emission is usually referred to as a fluorescent light-emitting material. A light-emitting layer made of the fluorescent light-emitting material is referred to as a fluorescent light-emitting layer. On the other hand, a guest material using phosphorescent light emission is usually referred to as a phosphorescent light-emitting material. A light-emitting layer made of the phosphorescent light-emitting material is referred to as a phosphorescent light-emitting layer.

Among them, in the phosphorescent light-emitting layer, in addition to 75% of triplet excitons that are generated according to recombination of electrons and holes, 25% of triplet excitons that are generated according to energy movement from singlet excitons can also be used. Therefore, in the phosphorescent light-emitting layer, 100% of internal quantum efficiency is obtained theoretically. That is, excitons generated according to recombination of electrons and holes are converted into light without causing thermal deactivation within the light-emitting layer. Actually, in the organic metal complex including heavy atoms such as iridium and platinum, about 100% of internal quantum efficiency is achieved according to optimization of an element structure.

The guest material of the phosphorescent light-emitting layer is not particularly limited. For example, as the red phosphorescent light-emitting layer, a red phosphorescent light-emitting material such as Ir(piq)₃ or Ir(btpy)₃ can be used. As a specific red phosphorescent light-emitting material, for example, 688118-250MG or 680877-250MG commercially available from Sigma-Aldrich Co. can be used.

On the other hand, as the green phosphorescent light-emitting layer, a green phosphorescent light-emitting material such as Ir(ppy)₃ can be used. As a specific green phosphorescent light-emitting material, for example, 694924-250MG commercially available from Sigma-Aldrich Co. can be used.

As host materials of the red phosphorescent light-emitting layer and the green phosphorescent light-emitting layer, a material having an electron transporting property, a material having a hole transporting property, or a material obtained by mixing both materials can be used. Specifically, for example, 4,4'-biscarbazolylbiphenyl (CBP), and 2,9-dimethyl-4,7-diphenyl-9,10-phenanthroline (BCP) can be used as host materials of the red phosphorescent light-emitting layer and the green phosphorescent light-emitting layer.

On the other hand, Alq and the like can be used as a host material of the green fluorescent light-emitting layer. Coumarin 6 and the like can be used as a guest material of the green fluorescent light-emitting layer.

On the other hand, for example, a blue fluorescent light-emitting material described in paragraphs [0052] to [0061] of "PCT International Publication No. WO 2012/053216" can be used as a host material and a guest material of the blue fluorescent light-emitting layer. For example, a styrylamine compound, a fluoranthene compound, an aminopyrene compound, and a boron complex can be used as a guest material.

In this embodiment, in order to increase an element lifespan and implement a high color-rendering property, the blue fluorescent light-emitting material is preferably used as a guest material of the blue light-emitting layer. On the other hand, when a blue phosphorescent light-emitting layer is used in place of the blue fluorescent light-emitting layer, a blue phosphorescent light-emitting material such as Ir(Fppy)₃ can be used. As a specific phosphorescent light-emitting material, for example, 682594-250MG commercially available from Sigma-Aldrich Co. can be used.

In this case, in this embodiment, blue light emitted from the blue fluorescent light-emitting layer has two peak wavelengths p₃ and p₄. A light-emitting material including a plurality of peak wavelengths in a certain wavelength range is generally provided. However, usually, in consideration of application to a display device such as a display, in order to improve color purity, a method of designing an element structure to emphasize one peak wavelength is used. Specifically, a method in which interference of light is used and a film thickness is set so that a light emission intensity at a certain wavelength is maximized is used. On the other hand, this embodiment is intended to be applied mainly to lighting devices. In this case, in order to obtain white light having a color temperature and a high color-rendering property over a wide range, it is preferable to implement an interference design such that two or more peak wavelengths appear in the blue wavelength range.

The charge-generating layer 31 includes an electrically-insulating layer made of an electron-accepting material and an electron-donating material. A specific resistance of the electrically-insulating layer is preferably 1.0×10² Ω•cm or more, and more preferably 1.0×10⁵ Ω•cm or more.

The charge-generating layer 31 is a mixed layer including different materials. One component of the charge-generating layer 31 may be a metal oxide. The metal oxide may form a charge-transfer complex according to an oxidation-reduction reaction. In this case, when a voltage is applied between the cathode 1 and the anode 2, charges in the charge-transfer complex move toward the cathode 1 side and the anode 2 side. As a result, holes are injected into one light-emitting unit (the first light-emitting unit 21 or the second light-emitting unit 22) that is positioned on the cathode 1 side with the charge-generating layer 31 interposed therebetween, and electrons are injected into the other light-emitting unit (the second light-emitting unit 22 or the first light-emitting unit 21) that is positioned on the anode 2 side with the charge-generating layer 31 interposed therebetween. Accordingly, light is simultaneously emitted from the first light-emitting unit 21 and the second light-emitting unit 22 at the same amount of current without change. Therefore, it is possible to obtain current efficiency and external quantum efficiency corresponding to the number of first light-emitting units 21 and second light-emitting units 22.

The charge-generating layer 31 may have a laminated body including an electron-accepting material and an electron-donating material. In this case, when a voltage is applied between the cathode 1 and the anode 2, at an interface between the electron-accepting material and the electron-donating material, charges generated by a reaction according to electron movement between the electron-accepting material and the electron-donating material move toward the cathode 1 side and the anode 2 side. As a result, holes are injected into one light-emitting unit (the first light-emitting unit 21 or the second light-emitting unit 22) that is positioned on the cathode 1 side with the charge-generating layer 31 interposed therebetween, and electrons are injected into the other light-emitting unit (the second light-emitting unit 22 or the first light-emitting unit 21) that is positioned on the anode 2 side with the charge-generating layer 31 interposed therebetween. Accordingly, light is simultaneously emitted from the first light-emitting unit 21 and the second light-emitting unit 22 at the same amount of current without change. Therefore, it is possible to obtain current efficiency and external quantum efficiency corresponding to the number of first light-emitting units 21 and second light-emitting units 22.

As a specific material of the charge-generating layer 31, for example, materials described in Patent Literature 9 can be used. Among them, materials described in paragraphs [0019] to [0021] can be suitably used. Materials described in paragraphs [0023] to [0026] of "PCT International Publication No. WO 2010/113493" can be used. Among them, in particular, a strong electron-accepting material (HATCN6) described in paragraph [0059] is a material that has been recently frequently used for the charge-generating layer 31.

In the lighting device of the embodiment to which the present invention is applied, a configuration including an optical film can be provided on a light extraction surface side of the organic EL element in order to improve efficiency and luminance and maintain a color-rendering property.

Usually, the color-rendering property is frequently evaluated according to an average color-rendering index (Ra). The average color-rendering index (Ra) is represented by an average value of eight color-rendering indexes (R1 to R8). In addition, 7 color-rendering indexes including R9 that is used to evaluate color reproducibility of red, R12 that is used to evaluate color reproducibility of blue, R13 that is used to evaluate reproducibility of a skin color of Westerners, and R15 that is used to evaluate reproducibility of a skin color of Japanese are used.

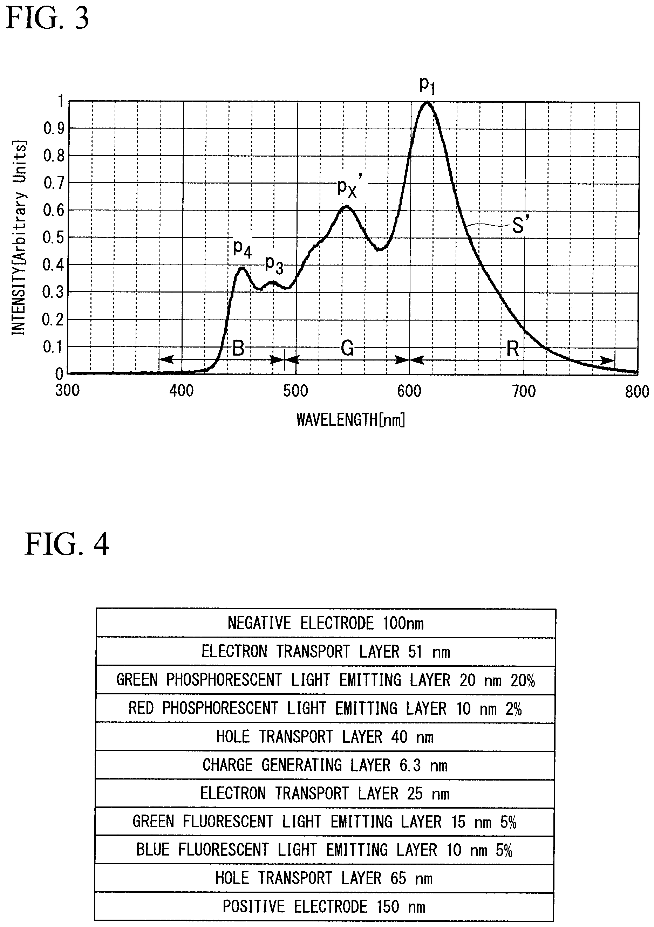

Fig. 3 is a graph showing an example of a light emission spectrum S' of white light obtained when an optical film is used. Specifically, white light obtained when the optical film is used has a light emission spectrum S' that is continuous over a wavelength range of at least 380 to 780 nm as shown in Fig. 3.

The light emission spectrum S' includes one peak wavelength p₁ in the red wavelength range of 600 to 780 nm, at least one peak wavelength p_{X}' in the green wavelength range of 490 to 600 nm, and two peak wavelengths p₃ and p₄ in the blue wavelength range of 380 to 490 nm.

Accordingly, a lighting device of an embodiment to which the present invention is applied can obtain white light having a color temperature and a high color-rendering property over a wide range. Specifically, the lighting device can obtain white light in which Ra is 70 or more (more preferably 80 or more), and among special color-rendering indexes, R9 is 30 or more, R12 is 60 or more, and R13 and R15 are 70 or more.

It is generally known that, in the organic EL element, light is emitted from an inside of a light-emitting layer that has a higher refractive index (refractive index of about 1.6 to 2.1) than air and only about 15 to 20% of light among light emitted from the light-emitting layer is extracted. This is because total reflection of light incident on an interface at an angle of a critical angle or greater is caused, the light is unable to be extracted to the outside of the element, total reflection of light is caused between a transparent electrode or a light-emitting layer and a transparent substrate, light is guided through the transparent electrode or the light-emitting layer, and as a result, light escapes in an element lateral direction.

Exemplary methods of improving light extraction efficiency include a method in which unevenness is formed on a surface of a transparent substrate, and total reflection at an interface between the transparent substrate and air is prevented (for example, refer to "United States Patent No. 4,774,435 specification"), a method in which a substrate has a light-collecting property and thus efficiency is improved (for example, refer to "Japanese Unexamined Patent Application, First Publication No. S63-314795"), a method in which a reflective surface is formed on a side surface of an element (for example, refer to "Japanese Unexamined Patent Application, First Publication No. H1-220394"), a method in which a flat layer having an intermediate refractive index is introduced between a substrate and a light-emitting body, and an antireflection film is formed (for example, refer to "Japanese Unexamined Patent Application, First Publication No. S62-172691"), a method in which a flat layer having a lower refractive index than a substrate is introduced between a substrate and a light-emitting body (for example, refer to "Japanese Unexamined Patent Application, First Publication No. 2001-202827"), and a method in which a diffraction grating is formed at a gap between a substrate and any of a transparent electrode layer and a light-emitting layer (including a gap between a substrate and the outside) (for example, refer to "Japanese Unexamined Patent Application, First Publication No. H11-283751").

Note that the lighting device has a structure in which a microlens array and the like are additionally provided on a surface of the optical film or a structure in combination with a light collecting sheet in order to improve the above-described color-rendering property. Therefore, in the lighting device, light is collected in a specific direction, for example, a forward direction with respect to an element light-emitting surface, and thus it is possible to increase luminance in a specific direction. In order to control a light emission angle from the organic EL element, a light diffusion film may be used together with a light-collecting sheet. As such a light diffusion film, for example, a light diffusion film (light up) commercially available from KIMOTO can be used.

Note that the present invention is not necessarily limited to the embodiment, but can be variously changed without departing from the scope and spirit of the present invention.

Specifically, in the organic EL element to which the present invention is applied, the element structure shown in Fig. 2 is suitably employed as the element structure for obtaining white light having a color temperature and a high color-rendering property over a wide range (a light emission spectrum S) shown in Fig. 1 described above, but the present invention is not necessarily limited to such an element structure. That is, as the element structure of the organic EL element to which the present invention is applied, as long as the white light having a color temperature and a high color-rendering property over a wide range (a light emission spectrum S) shown in Fig. 1 described above is obtained, it is possible to employ various element structures and materials accordingly.

### [Examples]

Hereinafter, effects of the present invention will become more apparent from the following examples. However, the present invention is not limited to the following examples, but can be appropriately changed and implemented within ranges in which the scope and spirit of the invention are not changed.

### (Example 1)

In Example 1, an organic EL element having an element structure shown in Fig. 4 was prepared. Specifically, first, a soda lime glass substrate having a thickness of 0.7 mm in which an ITO film having a thickness of 150 nm, a width of 2 mm, and a sheet resistance of about 10 Ω/sq was formed was prepared. The substrate was ultrasonically washed with a neutral detergent, ion-exchanged water, acetone, and isopropyl alcohol for 5 minutes, then spin-dried, and additionally treated with UV/Os.

Next, component materials of layers shown in Fig. 4 were filled in deposition crucibles (made of tantalum or alumina) within a vacuum deposition apparatus. The substrate was set in the vacuum deposition apparatus, and heated under a reduced pressure atmosphere of a degree of vacuum of 1 × 10⁻⁴ Pa or less by supplying a current to the deposition crucibles, and the layers having predetermined film thicknesses were deposited at a deposition rate of 0.1 nm/sec. Layers including two or more materials such as the light-emitting layer were co-deposited by supplying a current to the deposition crucibles to be formed at a predetermined mixing ratio. A cathode having a predetermined film thickness was deposited at a deposition rate of 1 nm/sec.

A power source (KEITHLEY2425) was connected to the organic EL element prepared as described above, a constant current of 4 mA/cm² was supplied, and the organic EL element was caused to emit light. In this case, a light emission spectrum of light that was emitted from the organic EL element in a forward direction was measured by a multi-channel analyzer (PMA-11 commercially available from Hamamatsu Photonics).

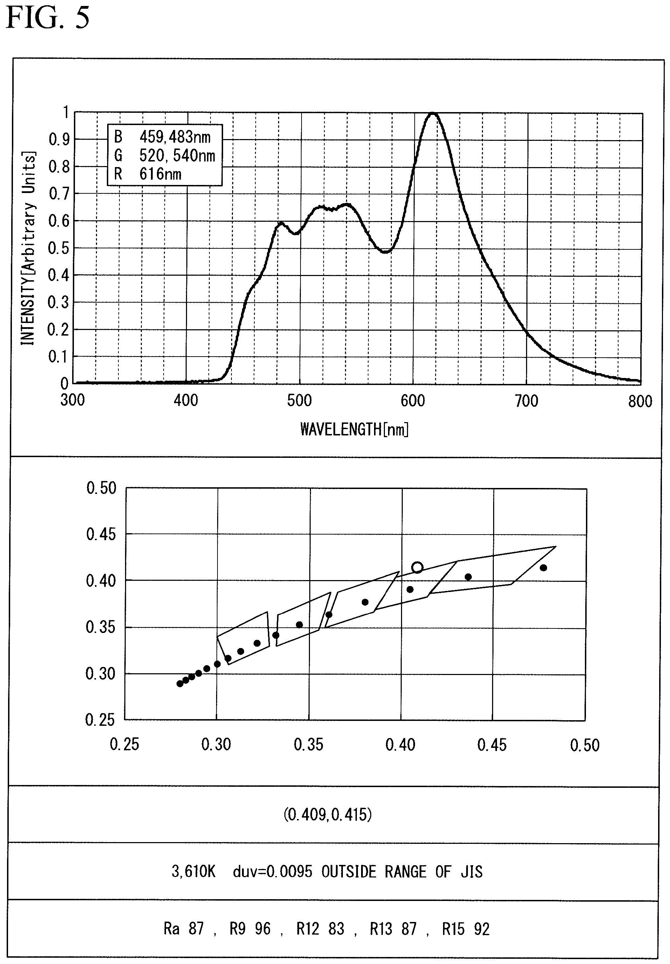

Based on the measurement result, light emission colors were evaluated according to chromaticity coordinates of the CIE standard colorimetric system. Based on the chromaticity coordinates, the light emission colors were classified into light source colors defined in JIS Z 9112. Based on the definition of JIS Z 8725, a deviation duv from a black body trajectory was derived. An average color-rendering index (Ra) of the light emission colors was derived by a method defined in JIS Z 8726. The evaluation results are summarized in Fig. 5.

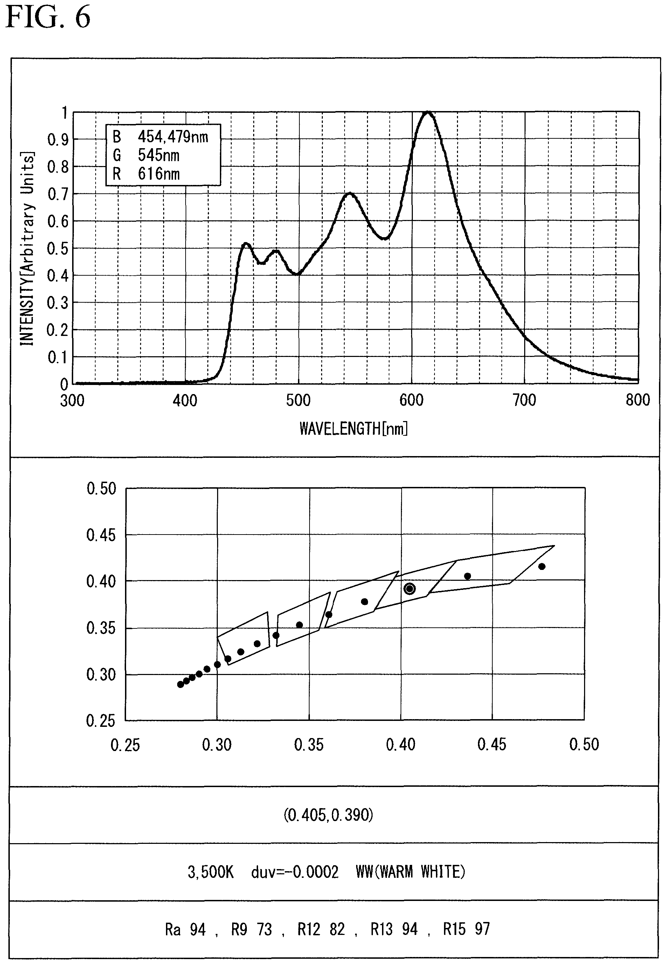

A light emission spectrum of white light obtained when an optical film was used was measured by the multi-channel analyzer (PMA-11 commercially available from Hamamatsu Photonics). Based on the measurement result, the light emission colors were evaluated according to chromaticity coordinates of the CIE standard colorimetric system. Based on the chromaticity coordinates, the light emission colors were classified into light source colors defined in JIS Z 9112. Based on the definition of JIS Z 8725, a deviation duv from a black body trajectory was derived. An average color-rendering index (Ra) of the light emission colors was derived by a method defined in JIS Z 8726. The evaluation results are summarized in Fig. 6.

### (Example 2)

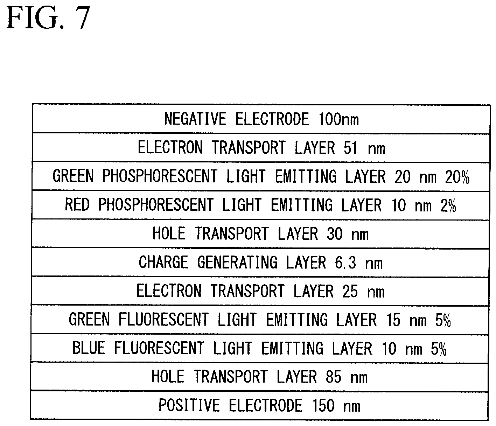

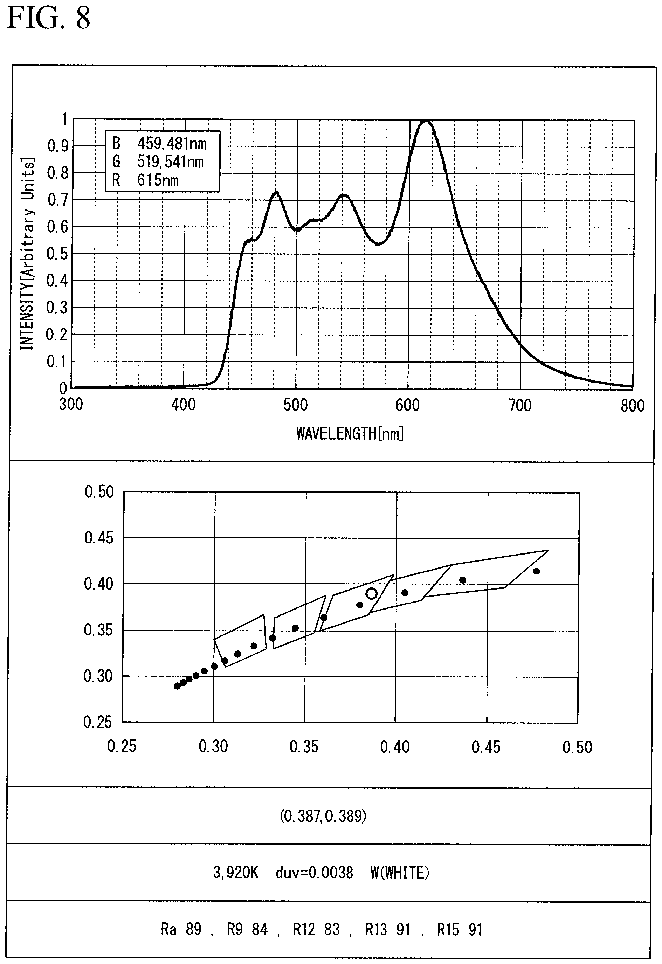

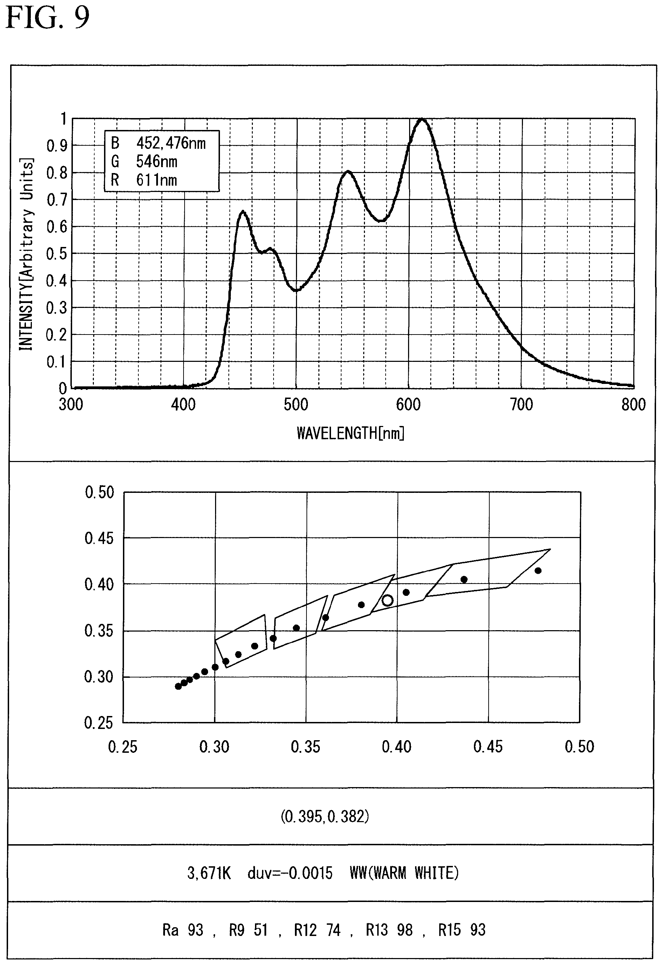

In Example 2, the same preparation method as in Example 1 was used, and an organic EL element having an element structure shown in Fig. 7 was prepared. The organic EL element of Example 2 was evaluated using the same method as in Example 1. The evaluation results are shown in Fig. 8 and Fig. 9. Here, Fig. 8 shows an evaluation result obtained when no optical film was provided, and Fig. 9 shows an evaluation result obtained when an optical film was provided.

### (Example 3)

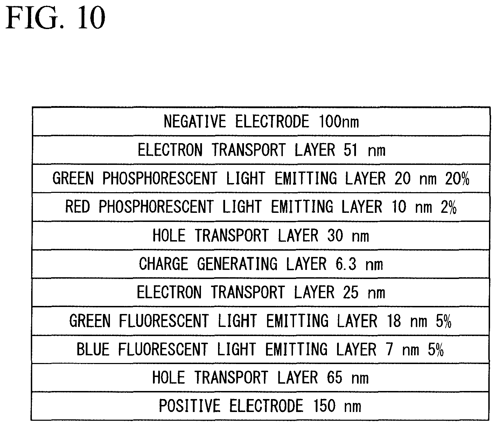

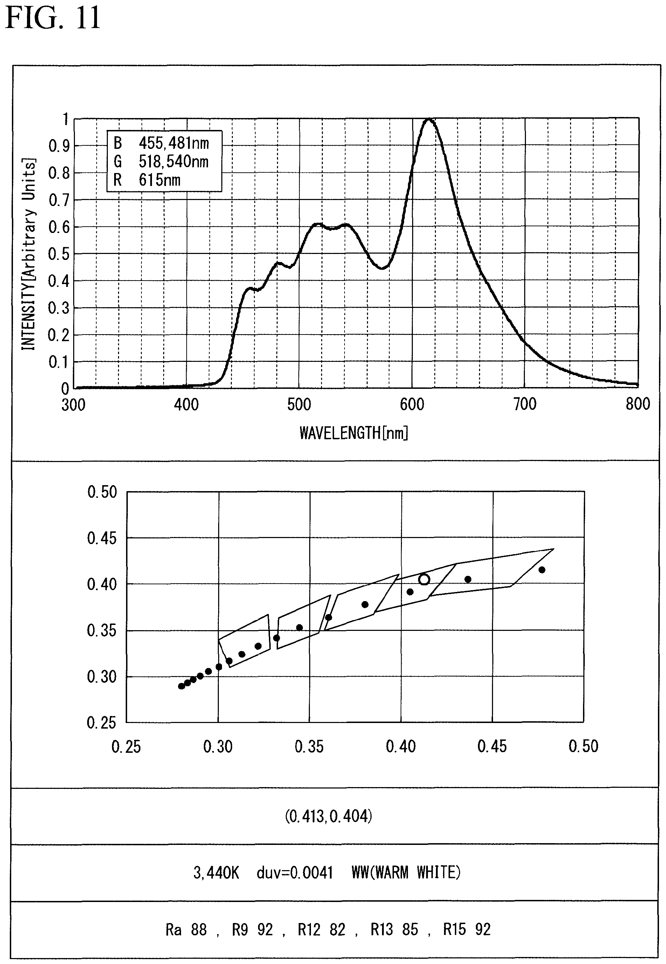

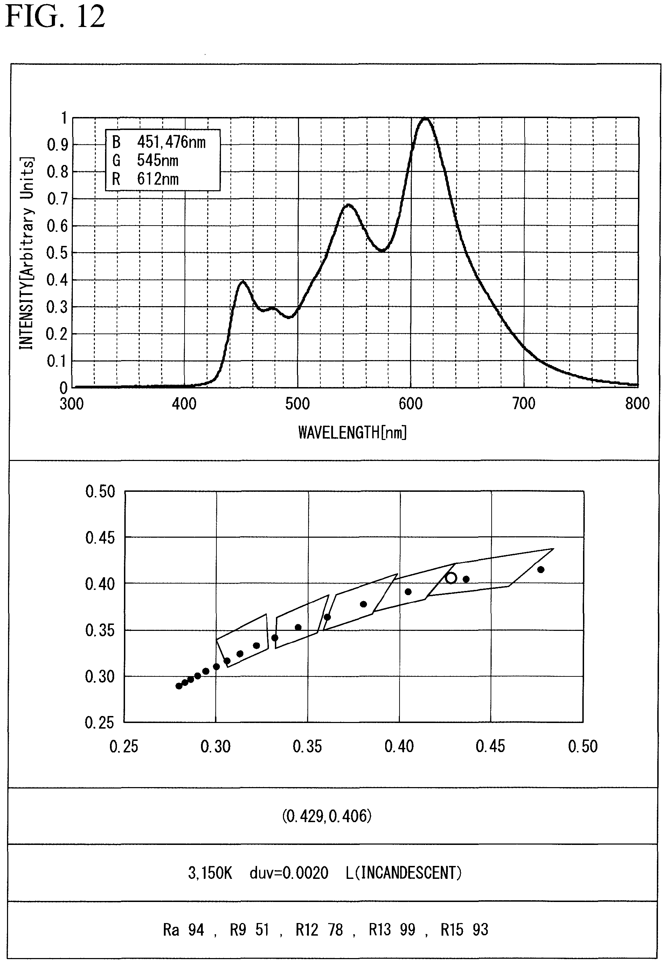

In Example 3, the same preparation method as in Example 1 was used to prepare an organic EL element having an element structure shown in Fig. 10. The organic EL element of Example 3 was evaluated using the same method as in Example 1. The evaluation results are shown in Fig. 11 and Fig. 12. Here, Fig. 11 shows an evaluation result obtained when no optical film was provided and Fig. 12 shows an evaluation result obtained when an optical film was provided.

### (Example 4)

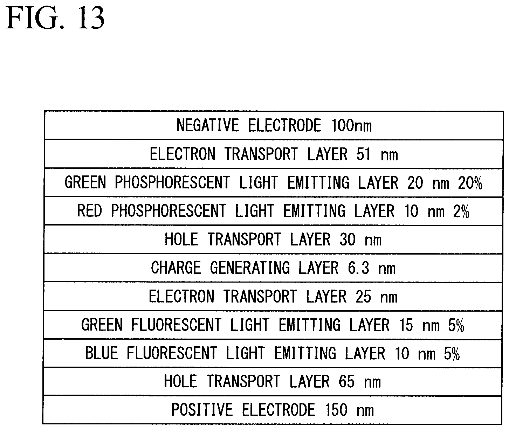

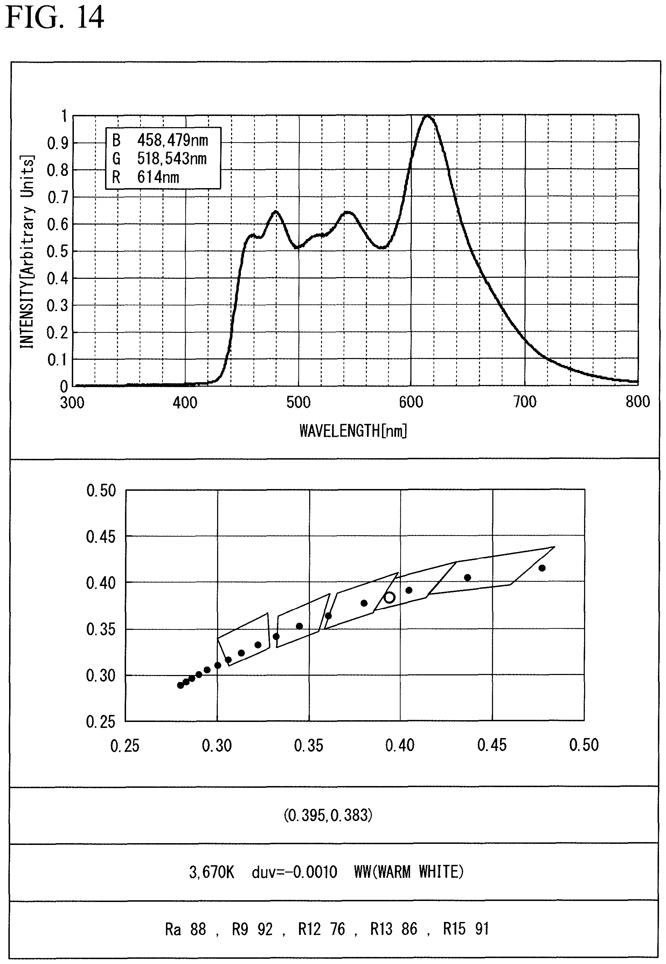

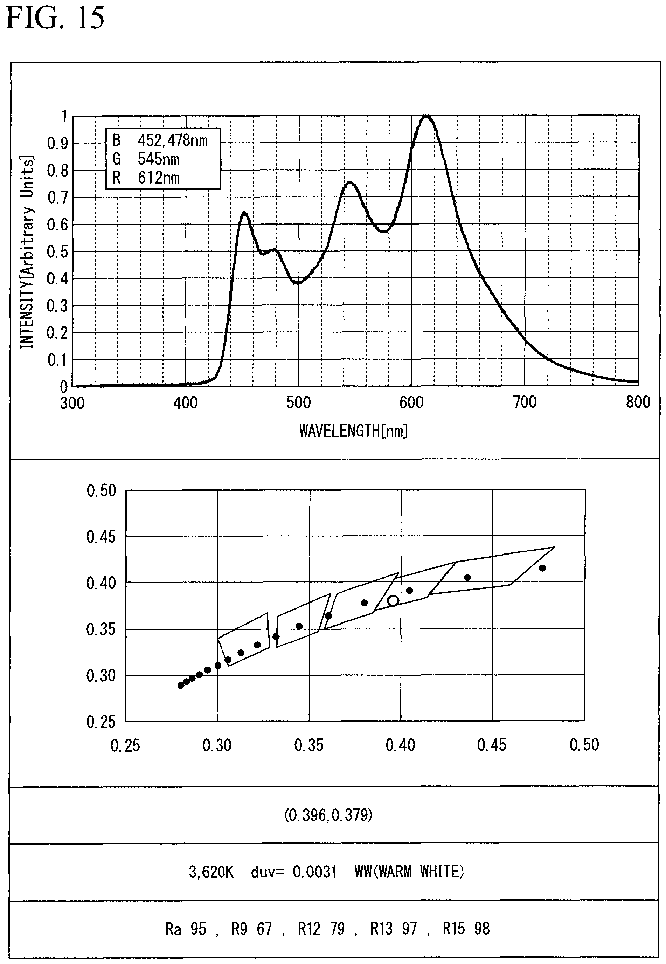

In Example 4, the same preparation method as in Example 1 was used to prepare an organic EL element having an element structure shown in Fig. 13. The organic EL element of Example 4 was evaluated using the same method as in Example 1. The evaluation results are shown in Fig. 14 and Fig. 15. Here, Fig. 14 shows an evaluation result obtained when no optical film was provided, and Fig. 15 shows an evaluation result obtained when an optical film was provided.

### (Example 5)

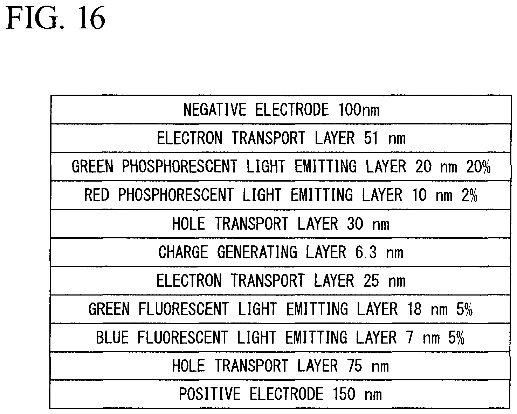

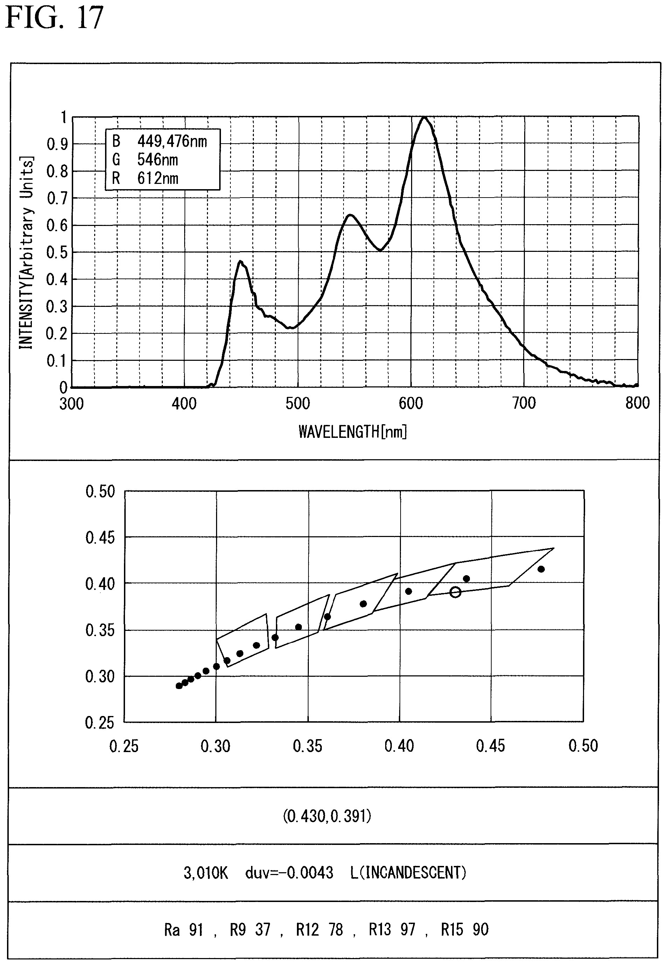

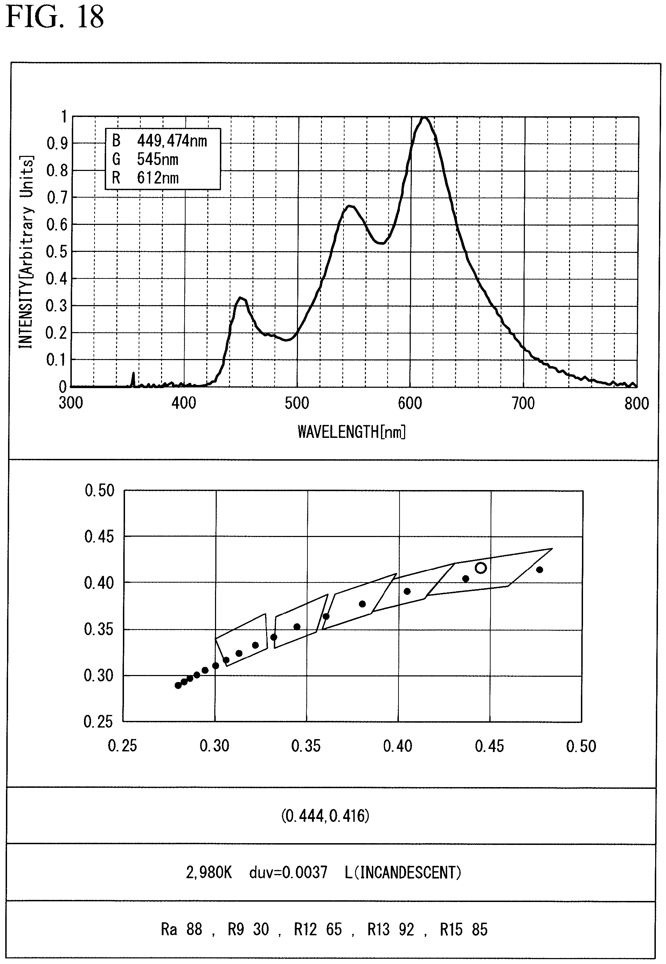

In Example 5, the same preparation method as in Example 1 was used to prepare an organic EL element having an element structure shown in Fig. 16. The organic EL element of Example 5 was evaluated using the same method as in Example 1. The evaluation results are shown in Fig. 17 and Fig. 18. Here, Fig. 17 shows an evaluation result obtained when no optical film was provided and Fig. 18 shows an evaluation result obtained when an optical film was provided.

As shown in the evaluation results of the aforementioned drawings, white light having a color temperature and a high color-rendering property over a wide range was obtained in all of the organic EL elements of Examples 1 to 5. Therefore, it can be seen that the lighting device including the organic EL element of the present invention in this manner can emit white light having a color temperature and a high color-rendering property over a wide range.

### [Industrial Applicability]

According to the organic electroluminescent element, white light having a color temperature and a high color-rendering property over a wide range is obtained.

### [Reference Signs List]

- 1: Cathode
- 2: Anode
- 21: First light-emitting unit
- 22: Second light-emitting unit
- 31: Charge-generating layer (CGL)
- S, S': Light emission spectrum
- R: Red wavelength range
- G: Green wavelength range
- B: Blue wavelength range
- p₁, p_{X}, p_{Y}, p_{X}', p₃, p₄: Peak wavelength

## Claims

1. An organic electroluminescent element comprising a plurality of light-emitting units that are provided between a cathode and an anode and include a light-emitting layer made of at least an organic compound,
wherein white light obtained by light emission of the plurality of light-emitting units has a light emission spectrum that is continuous over a wavelength range of at least 380 to 780 nm, and the light emission spectrum includes one peak wavelength in a red wavelength range of 600 to 780 nm, at least one or two peak wavelengths in a green wavelength range of 490 to 600 nm, and two peak wavelengths in a blue wavelength range of 380 to 490 nm.

2. The organic electroluminescent element according to Claim 1,
wherein a first light-emitting unit including a red phosphorescent light-emitting layer that emits red light having one peak wavelength in the red wavelength range and a green phosphorescent light-emitting layer that emits green light having one peak wavelength in the green wavelength range, and a second light-emitting unit including a blue fluorescent light-emitting layer that emits blue light having two peak wavelengths in the blue wavelength range and a green fluorescent light-emitting layer that emits green light having one peak wavelength in the green wavelength range are provided.

3. The organic electroluminescent element according to Claim 2,
wherein, in the second light-emitting unit, the blue fluorescent light-emitting layer is disposed on the anode side and the green fluorescent light-emitting layer is disposed on the cathode side.

4. The organic electroluminescent element according to Claim 2 or 3,
wherein red light emitted from the red phosphorescent light-emitting layer and green light emitted from the green phosphorescent light-emitting layer are obtained by triplet excitons, and
wherein blue light emitted from the blue fluorescent light-emitting layer is obtained by singlet excitons generated by collision and fusion of triplet excitons.

5. The organic electroluminescent element according to any one of Claims 1 to 4,
wherein the white light has a light emission color that is any of white (W), warm white (WW), and incandescent (L) among chromaticity ranges defined in JIS Z 9112.

6. The organic electroluminescent element according to any one of Claims 1 to 5,
wherein, when the white light has a light emission color that is any of warm white (WW) and incandescent (L) among chromaticity ranges defined in JIS Z 9112, and a maximum light emission intensity of a peak wavelength of red light is set as PR, a maximum light emission intensity of a peak wavelength of green light is set as PG, and a maximum light emission intensity of a peak wavelength of blue light is set as PB, relationships of PG/PR≤0.85 and PB/PR≥0.15 are satisfied.

7. The organic electroluminescent element according to any one of Claims 1 to 6,
wherein the white light has an average color-rendering index (Ra) of 70 or more, and among special color-rendering indexes, R9 is 30 or more, R12 is 60 or more, and R13 and R15 are 70 or more.

8. The organic electroluminescent element according to any one of Claims 1 to 7,
wherein the organic electroluminescent element has a structure in which the plurality of light-emitting units are laminated with a charge-generating layer interposed therebetween.

9. The organic electroluminescent element according to Claim 8,
wherein the charge-generating layer is an electrically-insulating layer made of an electron-accepting material and an electron-donating material, and the electrically-insulating layer has a specific resistance of 1.0×102 Ω•cm or more.

10. The organic electroluminescent element according to Claim 9,
wherein the electrically-insulating layer has a specific resistance of 1.0×105 Ω•cm or more.

11. The organic electroluminescent element according to Claim 8,
wherein the charge-generating layer is a mixed layer including different materials, one component is a metal oxide, and the metal oxide forms a charge-transfer complex according to an oxidation-reduction reaction, and
wherein, when a voltage is applied between the cathode and the anode, charges in the charge-transfer complex move toward the cathode side and the anode side, and thus holes are injected into one light-emitting unit that is positioned on the cathode side with the charge-generating layer interposed therebetween, and electrons are injected into the other light-emitting unit that is positioned on the anode side with the charge-generating layer interposed therebetween.

12. The organic electroluminescent element according to Claim 8,
wherein the charge-generating layer has a laminated body including an electron-accepting material and an electron-donating material, and
wherein, when a voltage is applied between the cathode and the anode, at an interface between the electron-accepting material and the electron-donating material, charges generated by a reaction according to electron movement between the electron-accepting material and the electron-donating material move toward the cathode side and the anode side, and holes are injected into one light-emitting unit that is positioned on the cathode side with the charge-generating layer interposed therebetween and electrons are injected into the other light-emitting unit that is positioned on the anode side with the charge-generating layer interposed therebetween.

13. A lighting device comprising the organic electroluminescent element according to any one of Claims 1 to 12.

14. The lighting device according to Claim 13,
wherein an optical film is provided on a light extraction surface side of the organic electroluminescent element.

15. The lighting device according to Claim 14,
wherein white light extracted from the optical film side has a light emission spectrum that is continuous over a wavelength range of at least 380 to 780 nm, and the light emission spectrum includes one peak wavelength in the red wavelength range of 600 to 780 nm, at least one peak wavelength in the green wavelength range of 490 to 600 nm, and two peak wavelengths in the blue wavelength range of 380 to 490 nm.

16. The lighting device according to Claim 14 or 15,
wherein white light extracted from the optical film side has Ra of 70 or more, and among color-rendering indexes, R9 is 30 or more, R12 is 60 or more, and R13 and R 15 are 70 or more.
